# EUROPEAN PATENT APPLICATION

(11) **EP 1 919 269 A1**
(43) Date of publication of application: **07.05.2008**
(21) Application number: 07020317.9
(22) Date of filing: 17.10.2007
(51) Int. Cl.: H05K 5/02

(54) **Housing for electrical devices**

(30) Priority: 03.11.2006 IT MI20062112
(71) Applicant: HERHOLDT CONTROLS S.R.L., 20132 Milano (IT)
(72) Inventor: Herholdt, Hans Albin, 20052 Monza (Prov. of Milano) (IT)
(74) Representative: Alagem Modiano, Lara S.

(57) **Abstract**

A housing (1) for electrical devices, comprising a box-like body (2) which is adapted to accommodate an electrical device, the box-like body (2) being provided with at least one slot (3) which faces at least one cavity (5) for accommodating a strip (10) which contains certification data of the device, the slot (3) being arranged so as to allow the insertion of the strip (10) within the cavity (5) but prevent its removal.

## Description

The present invention relates to a housing for electrical devices. More particularly, the invention relates to a housing for electrical devices which is adapted to prevent tampering of certification data provided by assigned authorities regarding the electrical device contained in the housing.

As is known, current electrical devices must be certified by assigned authorities, which issue a sort of type-approval which comprises for example the number of the device, the approval date, the precision class, the installation type, the rated value for nominal operating voltage, the rated value for nominal capacity, and the like.

Such data are usually applied by means of a plate to the housing, but in a position which can be accessed easily by anyone.

In particular, such data can also be screen-printed or laser-printed onto the housing and therefore can be easily accessed and altered.

If the data are applied by means of a plate, such plate is not concealed in any way and can be removed easily from its seat.

This entails the possibility that the plate might be tampered with and replaced with a plate having different values without leaving any trace.

The aim of the present invention is to provide a housing for electrical devices which allows to apply a device certification plate or strip so that the strip or plate cannot be removed fraudulently.

Within this aim, an object of the present invention is to provide a housing for electrical devices which allows to apply the strip or plate to the housing in a substantially nonremovable manner, allowing to detect any attempts at tampering.

Another object of the present invention is to provide a housing for an electrical device which therefore provides high assurances of safety.

Still another object of the present invention is to provide a housing for electrical devices which is highly reliable, relatively simple to provide and at competitive costs.

This aim and these and other objects, which will become better apparent hereinafter, are achieved by a housing for electrical devices, comprising a box-like body which is adapted to accommodate an electrical device, characterized in that said box-like body is provided with at least one slot which faces at least one cavity for accommodating a strip which contains certification data of said device, said slot being arranged so as to allow the insertion of the strip within said cavity but prevent its removal.

Further characteristics and advantages of the invention will become better apparent from the description of a preferred but not exclusive embodiment of the housing according to the present invention, illustrated by way of non-limiting example in the accompanying drawings, wherein:

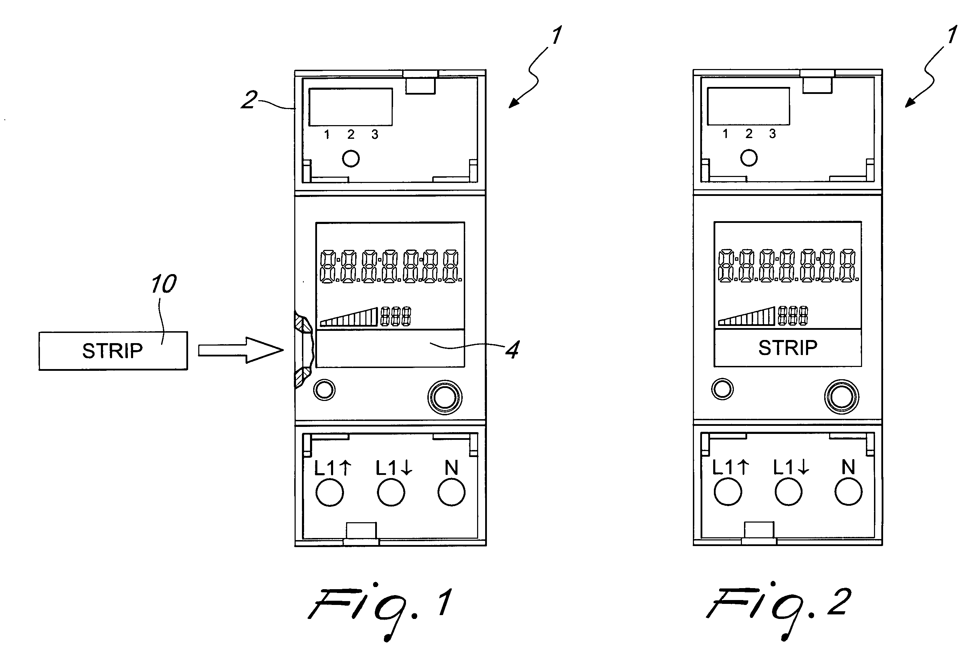

Figure 1 is a front view of the housing according to the present invention;
Figure 2 is a front view of the housing according to the present invention, with the certification strip inserted;

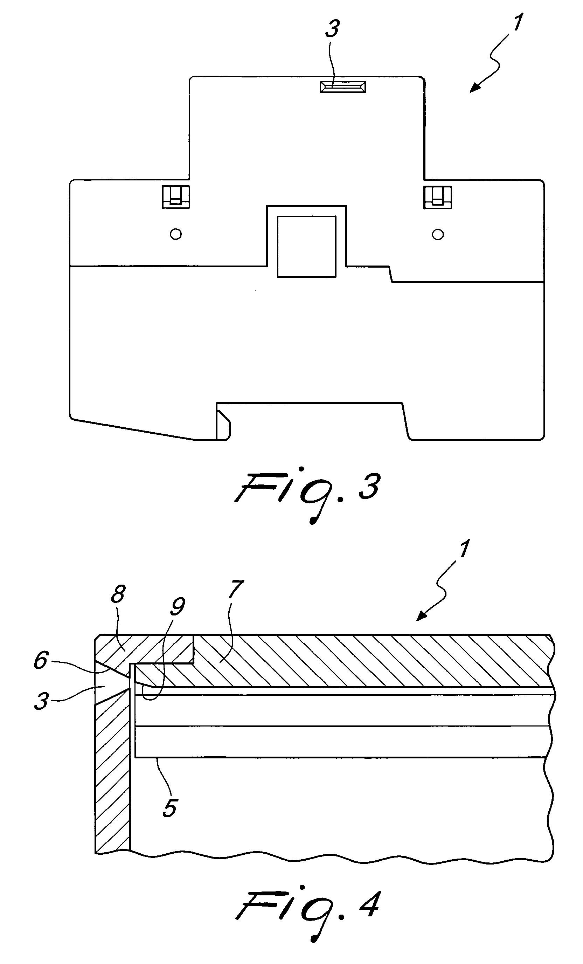

Figure 3 is a side elevation view of the housing according to the present invention;
Figure 4 is a transverse sectional view of the housing according to the present invention.

With reference to the figures, the housing according to the present invention, generally designated by the reference numeral 1, comprises a substantially box-like body 2, which is adapted to accommodate an electrical device.

The peculiarity of the invention resides in that the box-like body is provided with at least one slot 3 which is adapted to allow the insertion of a certification strip or plate into the housing.

Conveniently, the housing 1 is provided with a transparent window 4 at at least one cavity 5 defined inside the housing at the slot 3.

Conveniently, the slot 3 is contoured with an inlet 6 which is for example cone-shaped and faces the cavity 5.

Conveniently, the housing is further provided with a lid 7 which, when mated with a base 8 of the housing 1, abuts at the level of the cone-shaped inlet 6, so that an end portion 9 of the lid 7 blends substantially without discontinuities with the upper region of the inlet of the slot 3.

Conveniently, therefore, the slot 3 and the lower surface of the lid 7 of the housing define a passage for an identification strip or plate 10, on which it is possible to provide device certification data. The strip 10, once inserted within the slot 3, passes in contact with the lower surface of the lid 7 and then slides into the cavity 5 and can no longer be removed from the housing due to the fact that it is retained by the edge of the housing proper, i.e., the slot 3 and the lower surface of the lid 7 substantially prevent extraction of the strip 10 from its containment cavity 5 without opening the housing, i.e., without removing the lid 7.

Of course, removal of the lid 7 cannot occur without leaving indelible traces of this operation, thus allowing surveillance personnel to realize that an attempt to tamper with the device has occurred.

Therefore, the solution described above of providing at least one slot which is arranged for example at the lateral surface of the housing 1, so that the strip 10 can be inserted within the slot and thus be accommodated in the cavity 5, allows to associate permanently with the device a strip of paper or other material which contains the certification data of said device, with the assurance that said strip cannot be removed from the device without leaving evident traces of this operation.

Therefore, device safety is maximum, since the device cannot be opened and in particular it is not possible to remove from said device the strip of paper which contains the device certification data.

The housing for the device thus conceived is susceptible of numerous modifications and variations, all of which are within the scope of the appended claims; all the details may further be replaced with other technically equivalent elements.

In practice, the materials used, as well as the contingent shapes and dimensions, may be any according to requirements and to the state of the art.

The disclosures in Italian Patent Application No. MI2006A002112 from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A housing (1) for electrical devices, comprising a box-like body (2) which is adapted to accommodate an electrical device, **characterized in that** said box-like body (2) is provided with at least one slot (3) which faces at least one cavity (5) for accommodating a strip (10) which contains certification data of said device, said slot (3) being arranged so as to allow the insertion of the strip within said cavity (5) but prevent its removal.

2. The housing according to claim 1, **characterized in that** said slot (3) has an inlet (6) which is shaped like a cone in which the apex is directed toward said cavity (5) for containing said strip (10).

3. The housing according to one or more of the preceding claims, **characterized in that** said box-like body (2) is divided into a base portion (8) and a lid portion (7), said lid portion (7) mating with said base portion (8) and defining, together with said slot (3), a passage for the insertion of said strip (10) for accommodation within said cavity (5).

4. The housing according to one or more of the preceding claims, **characterized in that** said lid (7) has, at the lower surface directed toward said cavity (5) and at the inlet (6) of said slot (3), an inclined profile which is adapted to blend with the cone-like shape of said inlet (6) of the slot (3).
